# EUROPÄISCHE PATENTANMELDUNG

(11) **EP 0 774 765 A2**
(43) Veröffentlichungstag der Anmeldung: **21.05.1997**
(21) Anmeldenummer: 96203112.6
(22) Anmeldetag: 07.11.1996
(51) Int. Cl.: H01G 4/005

(54) **Verfahren zur Herstellung eines vielschichtigen keramischen Elektronikbauteils**

(30) Priorität: 14.11.1995 DE 19542365
(71) Anmelder: Philips Patentverwaltung GmbH, 22335 Hamburg (DE); PHILIPS ELECTRONICS N.V., 5621 BA Eindhoven (NL)
(72) Erfinder: Hagemann, Hans-Jürgen, Dr.,, 22335 Hamburg (DE); Lydtin, Hans-Jürgen, Dr.,, 22335 Hamburg (DE); Ritz, Arnd, Dr.,, 22335 Hamburg (DE); Warnier, Jacques,, 22335 Hamburg (DE)
(74) Vertreter: Schmalz, Günther

(57) **Zusammenfassung**

Verfahren zur Herstellung eines vielschichtigen keramischen Elektronikbauteils, das alternierend leitfähige Schichten und dielektrische Schichten umfaßt und in dem aufeinanderfolgende leitfähige Schichten abwechselnd aus zwei unterschiedlichen Elektrodenmaterialien gebildet werden, die bis an die Oberflächen aller vier Seitenflächen des Schichtträger heranreichen, bei dem eine Stirnseite des Schichtstapels in eine Elektrolytlösung eingetaucht und elektrochemisch das unedlere der beiden Elektrodenmaterialien herausgelöst wird, die dadurch entstandenen Hohlräume mit einem aushärtbaren Monomeren gefüllt werden, das edlere der beiden Elektrodenmaterialien durch Entfernung des entstandenen Polymerisats freigelegt und mit einem Potential belegt wird, das ausreicht, um das edlere der beiden Elektrodenmaterialien auf der anderen Stirnseite des Schichtstapels elektrochemisch herauszulösen und die auf der anderen Stirnseite entstandenen Hohlräume mit einem aushärtbaren Monomeren gefüllt und dann auf den gegenüberliegenden Seiten des Schichtstapels Außenelektroden angebracht werden.

## Beschreibung

Die vorliegende Erfindung betrifft ein Verfahren zur Herstellung eines vielschichtigen keramischen Elektronikbauteils, das alternierend aus leitfähigen Schichten und dielektrischen Schichten besteht, wobei die aufeinanderfolgenden leitfähigen Schichten abwechselnd aus zwei unterschiedlichen Elektrodenmaterialien gebildet werden.

Es ist bekannt, daß passive Vielschichtbauelemente und integrierte passive Vielschichtbaugruppen wie keramische Vielschicht-Kondensatoren für vielfältige Anwendungen benötigt werden. Ein Verfahren zur Herstellung eines solchen keramischen Elektronikbauteils wird nachfolgend für einen Mehrschicht-Kondensator beschrieben.

Bei einem herkömmlichen Verfahren zur Herstellung eines üblichen Mehrschicht-Kondensators wird häufig ein dreistufiges Verfahren angewendet. In der ersten Verfahrensstufe werden binderhaltige, keramische Grünfolien durch einen kontinuierlichen Gießprozeß aus einer binderhaltigen Suspension feinteiliger, keramischer Pulver hergestellt. Die Suspension wird in dünner Schicht auf ein Trägerband kontinuierlich aufgebracht und in einem Tunnelofen getrocknet. Der in der Suspension gelöste organische Binder trocknet auf der Oberfläche der dispergierten Pulverteilchen und verbindet diese zu flexiblen, porösen Folien. Derartige Folien können bspw. aus BaTiO₃ bestehen und haben im allgemeinen Schichtdicken von 25 bis 50 µm. Diese Grünfolien werden dann zur Kondensatorherstellung unter Anwendung einer Metallpaste im Siebdruck mit Elektroden bedruckt. Die durch die Metallisierung hergestellten Innenelektroden werden dabei so aufgedruckt, daß nur jede zweite Innenelektrodenschicht an die Ränder des Folienkondensators angrenzt. Die dazwischen liegende Metallschicht ist vom Rand zurückversetzt. Auf dieser Weise wird durch auf den Rändern aufgebrachte Außenelektroden jeweils nur jede zweite Innenelektrode kontaktiert. Die Grünfolie bildet das Dielektrikum.

Bei diesem Verfahren ist es jedoch schwierig, die Lückenbereiche zwischen den Innenelektroden und den Außenelektroden, welche nicht mit den Innenelektroden elektrisch verbunden sein dürfen, genau zu regulieren. Da die Innenelektroden durch das Drucken der leitfähigen Paste auf der Keramikgrünfolie ausgebildet werden, sind ihre Randbereiche durch Verzerrungen beim Siebdruck beim Stapeln und Fressen nicht genau festzulegen. Um in diesen Fällen eine elektrische Verbindung zwischen Innenelektrode und Außenelektrode zu vermeiden, müssen aus Sicherheitsgründen die Abstände erhöht werden, wodurch es unmöglich wird, den Vielschicht-Kondensator weiter zu miniaturisieren. Ein Ziel der Entwicklung im Bereich der keramischen Vielschichtbauelemente ("Ceramic Multilayer Devices" = CMD) ist die Verminderung der Baugröße bei gleichbleibender Funktionalität, die Integration kombinierter elektrischer Funktionen aus Kondensatoren, Widerständen und Induktivitäten in einem monolithischen Bauelement sowie die Erzielung höherer spezifischer Kapazitäten bei keramischen Vielschicht-Kondensatoren ("Ceramic Multilayer Capacitors" = CMC), die Verwendung von nicht-bedrahteten axialen Anschlußgeometrien ("Surface Mounted Devices" = SMD) und die Weiterentwicklung der Herstellungstechnologien mit dem Ziel der wirtschaftlichen Massenfertigung von zuverlässigen elektronischen Bauelementen.

Bei Vielschicht-Kondensatoren (CMC) ist das wichtigste Qualitätsmerkmal hinsichtlich Miniaturisierung die Größe der Kapazität pro Volumen. Da die Kapazität eines Vielschicht-Kondensators proportional zu nε/d ist, steigt die Kapazität pro Volumen bei Verminderung der Schichtdicke des Dielektrikums proportional zu ε/d², falls das ganze Volumen des Kondensators dielektrisch aktiv ist. Das ist jedoch im Zuge der Miniaturisierung immer weniger der Fall, weil die Dicke der Elektrodenschichten bisher nicht in gleichem Maße vermindert werden konnte wie die Dicke des Dielektrikums und weil die Breite der nicht mit Innenelektroden versehenen Randbereiche wegen geometrischer Fertigungstoleranzen nicht unter 200 bis 300 µm verringert werden konnte. Die Metallelektroden und die Randbereiche beanspruchen ein erhebliches Volumen des keramischen Vielschicht-Kondensators, tragen jedoch nicht zur Kapazität des Kondensators bei, d.h., bei Verwendung der konventionellen Technologien wächst im Zuge der Miniaturisierung unvermeidlich das Totvolumen der keramischen Vielschicht-Kondensatoren und setzt damit der Vergrößerung der Volumenkapazität und der Miniaturisierung eine prinzipielle Grenze. Ein weiteres sehr wichtiges Problem besteht darin, daß die absolute Positionierung der einzelnen Kleinen Komponenten (bis herunter zu 0,5 x 1 mm²) auf den großen Vielschichtplanen vielerlei Fehlern und Ungenauigkeiten unterliegt, z.B. Verzerrungen beim Siebdrucken, Verschiebungen beim Stapeln und beim Pressen sowie thermischen Einflüssen.

Bei dem üblichen Verfahren zur Herstellung von Vielschicht-Kondensatoren werden im einzelnen folgende Verfahrensschritte durchgeführt:

Aus geeigneten Keramiksuspensionen werden Folien gegossen oder gezogen, die das spätere keramische Dielektrikum in Pulverform zusammen mit Kleinen Mengen eines organischen Binders enthalten. Diese Folien sind typischerweise 20 bis 100 µm dick, bis zu 50 cm breit und möglicherweise viele hundert Meter lang. Die Folien werden mit einer Metallpaste als Ausgangsmaterial für die Innenelektronen im Siebdruckverfahren beschichtet und durch Stapelung zusammengefügt. Ein Stapel enthält dabei die Vorformen für Tausende oder gar Zehntausende von Vielschicht-Kondensatoren. Die Stapel werden durch Anwendung hoher axialer Drucke laminiert. Die so entstandenen Vielschichtplatten, die häufig Abmessungen von 100 x 100 mm² haben, werden durch eine geeignete mechanische Technik, wie Schneiden oder Brechen, in die einzelnen Vielschicht-Kondensator-Rohlinge getrennt. Eine wesentliche Bedingung ist dabei, daß die winzigen Elektrodenmuster für die inneren Elektroden der einzelnen Vielschicht-Kondensatoren in der richtigen Größe und den richtigen Abständen voneinander auf der bedruckten Folie vorgeformt und bei zwei aufeinanderfolgenden Schichten gegeneinander so versetzt werden, daß nach der Trennung in einzelnen Komponenten die Elektroden abwechselnd nach "rechts" oder nach "links" kontaktiert werden können, um damit die gewünschte Parallelschaltung der einzelnen Kondensatorlagen zu erreichen. Besondere Probleme, die jede Materialauswahl und Herstellungstechnik zu beachten haben, sind die notwendige hohe Durchschlagsfestigkeit der dielektrischen Schichten und die absolute Fehlerfreiheit der Schichten über große Flächen von bis zu mehreren hundert mm².

Obwohl nach den bekannten Verfahren Vielschicht-Kondensatoren in großen Stückzahlen und zu geringen Kosten hergestellt werden können, ist es als nachteilig anzusehen, daß wegen der angewandten Pulvertechnologie die für die dielektrischen und leitfähigen Schichten angewendeten Materialien den Bedingungen des Sinterprozesses standhalten müssen. Dies bedingt eine Be schränkung der einsetzbaren Materialsysteme.

Insbesondere findet während des Herstellungsprozesses die Umsetzung der in relativ dicken Schichten vorgegebenen Geometrie durch Pressen, Trocknen, Binderausbrand und Sintern in die endgültige Form mit relativ dünnen Schichten statt. Dies führt durch Fließen des Materials, Verschiebungen und inhomogenes Schrumpfen innerhalb der Schichtstapel zu Problemen. Auch ist das exakte Trennen in die einzelnen Kondensatoren ein Problem. Deshalb sind immer wieder Verfahren zur Verbesserung der Herstellung von Vielschicht-Kondensatoren vorgeschlagen worden.

So wird in der europäischen Patentanmeldung 606 607 die Herstellung eines Vielschicht-Kondensators beschrieben, bei dem auf ein Substrat ein Schichtaufbau aufgebracht wird, der alternierend leitfähige Schichten und dielektrische Schichten umfaßt und in dem aufeinanderfolgende leitfähige Schichten jeweils aus einem von zwei unterschiedlichen Materialien gebildet werden, die gegenseitig zueinander selektiv ätzbar sind. Dieses Verfahren ist jedoch auf die Herstellung von Vielschicht-Kondensatoren für den IC-Bereich gerichtet und erfordert aufwendige Masken- und Ätzschritte, die durch die gesamte Dicke des Schichtstapels, geführt werden müssen.

Das in der deutschen Offenlegungsschrift 44 10 504 beschriebene Verfahren zur Herstellung eines mehrschichtigen keramischen Elektronikbauteils mit einer verbesserten Ausbildung der Innenelektroden und der gesicherten Isolierung zwischen Innenelektroden und Außenelektroden erfordert eine sorgfältige Stapelung der Dielektrika und der Elektroden, um zu gewahrleisten, daß jede zweite Innenelektrode nicht bis zur Oberfläche des Körpers reicht. Diese Vorstrukturierung ist jedoch bei der Herstellung eines mehrschichtigen keramischen Elektronikbauteiles durch ein Dünnfilmherstellungsverfahren besonders aufwendig.

Wünschenswert ist deshalb ein Verfahren, bei dem eine Vorstrukturierung der Innenelektroden nicht mehr benötigt wird, der Herstellungsprozeß des strukturierenden Siebdrucks sowie Trocknen, Binderausbrand und Sintern nicht mehr erforderlich sind, um eine wesentliche Vereinfachung und Verbesserung der Herstellung von Vielschicht-Kondensatoren zu erreichen.

Dieses Ziel wird durch ein Verfahren zur Herstellung eines vielschichtigen keramischen Elektronikbauteils erreicht, das alternierend leitfähige Schichten und dielektrische Schichten umfaßt und in dem aufeinanderfolgende, leitfähige Schichten abwechselnd aus zwei unterschiedlichen Elektrodenmaterialien gebildet werden, die bis an die Oberflächen aller vier Seitenflächen heranreichen, bei dem
- zunächst eine Stirnseite des Schichtstapels in eine Elektrolytlösung eingetaucht und elektrochemisch das unedlere der beiden Elektrodenmaterialien herausgelöst wird,
- die dadurch entstandenen Hohlräume mit einem aus- härtbaren Monomeren gefüllt werden,
- das edlere der beiden Elektrodenmaterialien durch Entfernung des entstandenen Polymerisats freigelegt und mit einem Potential belegt wird, das ausreicht, um das edlere der beiden Elektrodenmaterialien auf der anderen Stirnseite des Schichtstapels in einer Elektrolytlösung elektrochemisch herauszulösen,
- die auf der anderen Stirnseite entstandenen Hohlräume mit einem aushärtbaren Monomeren gefüllt und dann
- auf den einander gegenüberliegenden Seiten des Schichtstapels Außenelektroden angebracht werden.

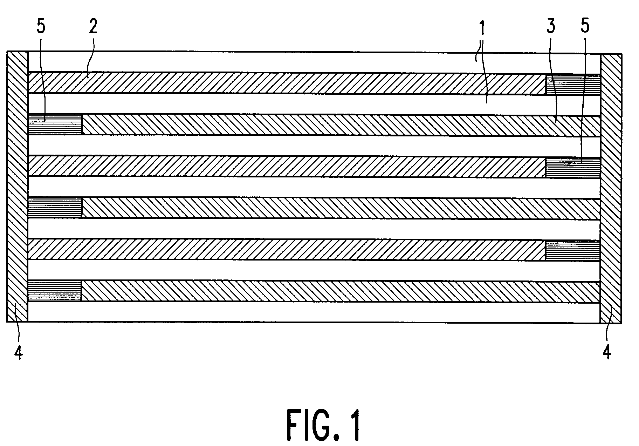

Die einzige Figur der Zeichnung zeigt den erfindungsgemäß hergestellten Schichtstapel, in dem die dielektrischen Schichten 1 alternierend mit leitfähigen Schichten des Elektrodenmaterials A 2 und des Elektrodenmaterials B 3 zu erkennen sind. Die leitfähigen Schichten sind abwechselnd an der "rechten" oder "linken" Seite mit einem Polymerpfropfen 5 verschlossen, der eine elektrische Verbindung zu der Außenelektrode 4 unterbindet.

In dem erfindungsgemäß hergestellten Schichtstapel wiederholt sich also nicht die bisher im allgemeinen angewendete Stapelfolge Dielektrikum - lateral strukturiertes Elektrodenmaterial, sondern die Stapelfolge Dielektrikum - Elektrodenmaterial A - Dielektrikum - Elektrodenmaterial B ohne jede laterale Strukturierung. Dieser Schichtenaufbau hat zur Folge, daß alle Elektrodenschichten, die später zur "rechten" Komponentenseite kontaktiert werden, aus einem Material bestehen, das sich vom Material aller Elektrodenschichten unterscheidet, die später zur "linken" Komponentenseite kontaktiert werden. Die Elektroden werden ganzflächig und homogen auf die elektrische Schicht aufgebracht, eine Vorstrukturierung der Elektrodenschichten entsprechend den lateralen Abmessungen der späteren Vielschicht-Kondensatoren findet also nicht statt.

Nach der Stapelung erfolgt zunächst die Trennung in Vorformen für die Einzelkomponenten, dann eine selektive seitenabhängige Elektrodenbehandlung und schließlich die Kontaktierung der Elektroden.

Die Trennung in Einzelkomponenten kann in bekannter Weise, z.B. durch Anritzen und Brechen oder Sägen oder ähnliche Verfahren vorgenommen werden. Nach der Trennung liegen Rohlinge von Vielschicht-Kondensatoren vor, bei denen alle Elektrodenschichten bis an die Oberflächen der vier Seitenflächen heranreichen. Der wesentliche Unterschied zu der konventionellen Herstellungsweise ist darin zu sehen, daß die Elektroden, die auf einer Stirnfläche isoliert werden müssen, sich im Material von allen Elektroden unterscheiden, die hier kontaktiert werden müssen.

Erfindungsgemäß werden zunächst Keramik-Grünplatten hergestellt, die dann ganzflächig und homogen mit dem Elektrodenmaterial A bzw. dem Elektrodenmaterial B gemäß einer der bekannten Dünnschichttechnologien beschichtet werden. Dabei kann sowohl die Dampfabscheidung oder das Sputtern oder eine elektrochemische Beschichtung zur Anwendung kommen. Ganz besonders vorteilhaft ist die Anwendung eines vollständigen Dünnfilmprozesses auch für die dielektrischen Lagen, z.B. durch ein laser- oder plasmaaktiviertes CVD (= Chemical Vapor Deposition)-Verfahren. Dieses Verfahren hat den großen Vorteil, daß von vorne herein kompakte Schichten abgeschieden werden und deshalb die Verfahrensschritte des Trocknens, des Binderausbrandes und des Sinterns ersatzlos wegfallen und damit auch alle Kompatibilitätsprobleme, die sonst beim Co-Sinterprozeß der Metall/Keramik-Vielschichtstruktur beachtet werden müssen. Als unmittelbarer weiterer Vorteil ergibt sich bei diesem Verfahren außerdem, daß dünnere Elektroden- und/oder -dielektrische Schichten hergestellt werden können und daher höhere Volumenkapazitäten erreichbar sind.

Hinzu kommt, daß die nicht mit Innenelekroden versehenen Randbereiche des Vielschicht-Kondensators von bisher 200 bis 400 µm auf 1 bis 5 µm oder sogar noch weniger vermindert werden können. Die Größe der Randbereiche, die ein nicht nutzbares Totvolumen darstellen, wird nur noch durch die Isolationseigenschaften der verwendeten Dielektrika und nicht mehr durch geometrische Toleranzen des Herstellungsprozesses bestimmt. Außerdem treten bei den nach konventionellen Verfahren hergestellten Vielschicht-Kondensatoren aufgrund der lateralen Strukturierung der Elektrodenlagen immer wieder fatale Verwerfungen der Vielschichtplatten auf, was bei der erfindungsgemäßen Herstellung einer lateral homogenen Vielschichtplatte grundsätzlich vermieden wird.

Ein weiterer Vorteil des erfindungsgemäßen Verfahrens ist darin zu sehen, daß die Trennung in Einzelkomponenten erst erfolgt, wenn die Vielschichtplatte fertig gesintert ist. Damit gewinnt das Herstellungsverfahren zusätzliche Flexibilität bezüglich der Abmessungen der Einzelkomponenten, die aus den Platten gefertigt werden. So können z.B. aus einer Platte verschieden große Vielschicht-Kondensatoren hergestellt werden, indem aus dem vorgefertigten Plattenstapel ein Vielschicht-Kondensator der gewünschten Größe herausgeschnitten wird.

Im einzelnen erfolgt die Herstellung des Vielschicht-Kondensators wie folgt:
a) Herstellung des Schichtstapels
   a1) Ähnlich wie bei einem konventionellen Herstellungsverfahren werden keramische Folien hergestellt und ganzflächig mit Elektrodenpaste mit Hilfe eines Siebdruckprozesses beschichtet. Dabei muß ein Teil der Folien mit dem Ausgangsmaterial für die Elektrode A, ein anderer Teil der Folie mit dem Ausgangsmaterial für die Elektrode B homogen beschichtet werden. Da die Vielschichtplatten typische Abmessungen von 100 x 100 mm² haben und ein gleichmäßiger Siebdruck auf so großen Flächen Probleme bereiten könnte, müssen in der Siebdruckmasse möglicherweise einige Stützstrukturen vorgesehen werden, die den für Komponenten nutzbaren Teil der Platten geringfügig vermindern. Dann erfolgt - wie im konventionellen Prozeß, jedoch ohne Versatz und ohne Einhaltung lateraler Toleranzen - die Stapelung in der Schichtenfolge Elekrode A - Dielektrikum - Elektrode B, das Laminieren, das Kerben und Brechen in die Schichtstapel, dann das Trocknen, der Binderausbrand und das Sintern. Danach erfolgt dann erfindungsgemäß die selektive, seitenabhängige Elektrodenbehandlung und Endkontaktierung.
   a2) Anstatt die Elektrodenschichten mit einem Dickschichtverfahren (Siebdruck) herzustellen, werden die Elektroden in einem Vakuumaufdampfschritt auf die keramischen Folien aufgebracht. Der Vorteil hierbei besteht darin, daß dünnere Elekrodenschichten möglich sind als mit dem Siebdruckverfahren, was zu einer Verminderung des Totvolumens der Bauelemente und damit zu einer Verkleinerung führt. Alle anderen Schritte bleiben gegenüber (a1) unverändert.
   a3) Anstatt von keramischen Folien auszugehen, werden die dielektrischen Schichten mit Hilfe eines CVD (Chemical Vapor Deposition)-Verfahrens, vorzugsweise plasma- oder laseraktiviert, oder eines Laser-Ablationsverfahrens abgeschieden. Die Abscheidung der Elektrodenschichten erfolgt im gleichen Rezipienten mit Hilfe eines geeigneten Dünnfilmverfahrens (Aufdampfen, Sputtern, CVD oder ähnliche Verfahren). Vorzugsweise werden alle Schichten (Elekrodenmaterial A, Dielektrikum, Elektrodenmaterial B) kompakt abgeschieden. Die einzelnen Abscheidevorgänge werden solange wiederholt, bis eine Platte mit der gewünschten Vielschichtstruktur hergestellt ist. Die konventionellen Prozeßschritte Trocknen, Binderausbrennen, Sintern können entfallen. Die Platte wird dann in die Vorläufer für die Einzelkomponenten zerteilt und dann die Elektroden selektiv behandelt.
b) Selektive Elektrodenbehandlung
   b1) Als Elektrodenmaterialien werden zwei verschiedene Metalle A und B mit unterschiedlichen Oxidationspotentialen verwendet. Man taucht nun eine Stirnfläche des Schichtstapels, die später einen der beiden Kopfkontakte tragen soll, in eine Elektrolytlösung unter Anlegung eines solchen Potentials ein, daß das unedlere der beiden Elektrodenmaterialien herausgelöst, das andere, edlere Elektrodenmaterial aber nicht angegriffen wird. Nach diesem Schritt hat man eine Stuktur erreicht, bei der die Elektrodenschichten abwechselnd bis zur Oberfläche reichen oder in einem Graben unter der Oberfläche liegen. Um eine ausreichende Isolation zum späteren Kopfkontakt des Vielschicht-Kondensators zu verwirklichen und zur Planarisierung der Oberfläche werden die Gräben mit einem Polymer hoher Durchschlagsfestigkeit gefüllt. Dies geschieht durch Aufbringen eines flüssigen, gut benetzenden Monomeren, das durch Belichtung ausgehärtt wird. Da nun die gesamte Oberfläche, auch die zu kontaktierenden Elektrodenschichten mit Polymer bedeckt sind, wird die Oberfläche in ein Bad getaucht, das die Polymeroberfläche löst. Dabei wird die Einwirkzeit so bemessen, daß die Oberfläche der Elektroden des edleren Metalls mit Sicherheit freigelegt werden, während die Gräben noch ausreichende Isolatordicken enthalten.
      Auf den beiden Seiten ("vorne" und "hinten"), wo beide Elektrodensorten zu isolieren sind, wird in gleicher Weise mit einem höheren Potential gearbeitet, so daß sich dort sowohl das unedlere als auch das edlere Metall löst.
      Im folgenden Verfahrensschritt müssen nun die Elektroden des edleren Metalls an der gegenüberliegenden Seite des Kondensators herausgelöst werden. Das laßt sich dadurch erreichen, daß über die zuerst behandelte Seite des Kondensators nur die Elektroden des edleren Metalls mit einem Potential belegt werden, da auf dieser Seite des Kondensators die aus dem unedleren Metall gebildeten Elektroden bereits isoliert sind.
      Die anschließende Endkontaktierung der "rechten" und der "linken" Elektroden wird mit einem Niedertemperaturschritt durchgeführt, z.B. durch Aufdampfen, Elektroplattierung oder ähnliches, da die isolierenden Polymere ja nicht durch Anwendung eines Einbrennprozesses bei hohen Temperatuen beschädigt werden dürfen.
   b2) Anstatt die selektive Elektrodenbehandlung auf elektrochemische Weise durchzuführen, können auch Festkörperreaktionen durchgeführt werden, die selektiv nur mit einem der Elektrodenmaterialien ablaufen, z.B. die Oxidation eines der Metalle. Falls das Reaktionsprodukt (z.B. ein Oxid) fest, isolierend und dicht ist, entfällt die Beschichtung der selektiv behandelten Stirnfläche mit einem isolierenden Material, weil für die Isolation ja schon durch das Reaktionsprodukt gesorgt ist. In diesem Fall ist die Kontaktierung auch durch einen konventionellen Einbrennprozeß für die Endkontaktierungspaste möglich, wobei im allgemeinen eine Temperatur von 900°C angewendet wird.
   b3) Anstatt nur eine Stirnfläche selektiv zu behandeln, kann mit ihr gemeinsam und gleichzeitig auch eine Behandlung der Seitenflächen erfolgen.
   b4) Zur Isolation der selektiv behandelten Elektroden kann anstelle eines Kunststoffes auch ein hoch-isolierendes Glas eingesetzt werden, das dann mit einem Einbrennprozeß für die Endkontakte kompatibel sein und gleichzeitig mit diesen eingebrannt werden kann.

Im Ergebnis hat das erfindungsgemäße Verfahren den Vorteil, daß die bisher erforderlichen aufwendigen Justierungen der übereinander liegenden Schichen entfallen, daß die elektrodenfreien Randbereiche sehr Klein gehalten werden können, daß alle Elektrodenschichten gleichzeitig in wenigen Verfahrensschritten behandelt werden und erfindungsgemäß eine effiziente Nutzung von Dünnfilmtechniken möglich ist.

## Patentansprüche

1. Verfahren zur Herstellung eines vielschichtigen keramischen Elektronikbauteils, das alternierend leitfähige Schichten und dielektrische Schichten umfaßt und in den aufeinanderfolgende leitfähige Schichten abwechselnd aus zwei unterschiedlichen Elektrodenmaterialien gebildet werden, die bis an die Oberflächen aller vier Seitenflächen des Schichtträger heranreichen,
dadurch gekennzeichnet, daß
- eine Stirnseite des Schichtstapels in eine Elektrolytlösung eingetaucht und elektrochemisch das unedlere der beiden Elektrodenmaterialien herausgelöst wird;
- die dadurch entstandenen Hohlräume mit einem aushärtbaren Monomeren gefüllt werden;
- das edlere der beiden Elektrodenmaterialien durch Entfernung des entstandenen Polymerisats freigelegt und mit einem Potential belegt wird, das ausreicht, um das edlere der beiden Elektrodenmaterialien auf der anderen Stirnseite des Schichtstapels elektrochemisch herauszulösen und
- die auf der anderen Stirnseite entstandenen Hohlräume mit einem aushärtbaren Monomeren gefüllt und dann
- auf den gegenüberliegenden Seiten des Schichtstapels Außenelektroden angebracht werden.

2. Verfahren nach Anspruch 1, wobei die Elektroden auf den Keramikgrünplatten durch ein Dünnfilmherstellungsverfahren ausgebildet werden.

3. Verfahren nach Anspruch 1 oder 2,
dadurch gekennzeichnet,
daß das Dünnfilmherstellungsverfahren durch Dampfabscheidung durchgeführt wird.

4. Verfahren nach Anspruch 1 oder 2,
dadurch gekennzeichnet,
daß das Dünnfilmherstellungsverfahren durch Sputtern durchgeführt wird.

5. Verfahren nach Anspruch 1 oder 2,
dadurch gekennzeichent,
daß das Dünnfilmherstellungsverfahren durch elektrochemisches Beschichten durchgeführt wird.

6. Verfahren nach einem der vorangehenden Ansprüche,
dadurch gekennzeichnet,
daß an eine in eine Elektrolytlösung eintauchende Stirnfläche des Schichtstapels ein Potential angelegt wird, das das unedlere der beiden Elektrodenmaterialien herauslöst, das edlere Elektrodenmaterial aber nicht angreift.

7. Verfahren nach einem der vorangehenden Ansprüche,
dadurch gekennzeichnet,
daß die Oberflächenseite des Schichtstapels, aus der das unedlere Elekrodenmaterial herausgelöst ist, mit einem Isolationsmaterial bestehend aus Polymeren hoher Durchschlagsfestigkeit oder aus Glas unter Bildung einer planaren Oberfläche ausgefüllt wird.

8. Verfahren nach einem der vorangehenden Ansprüche,
dadurch gekennzeichnet,
daß die Elektroden des edleren Materials über die zuerst behandelte Seite des Schichtstapels, in der die aus unedlerem Metall gebildeten Elektroden bereits isoliert sind, herausgelöst werden.

9. Verfahren nach einem der vorangehenden Ansprüche,
dadurch gekennzeichnet,
daß das vielschichtige keramische Elektronikbauteil ein Vielschicht-Kondensator ist.

10. Verfahren nach einem der vorangehenden Ansprüche,
dadurch gekennzeichnet,
daß das vielschichtige keramische Elektronikbauteil ein vielschichtiges, piezo-elektrisches Betätigungselement ist.
